# EUROPEAN PATENT APPLICATION

(11) **EP 0 608 920 A1**
(43) Date of publication of application: **03.08.1994**
(21) Application number: 94104454.7
(22) Date of filing: 03.02.1992
(51) Int. Cl.: H05K 3/00, B23B 35/00

(54) **Drilling printed circuit boards and entry and backing boards therefor**

(30) Priority: 07.02.1991 GB 9102672; 19.09.1991 GB 9120016
(62) Divisional of application: 92904277.8
(71) Applicant: HOLDERS TECHNOLOGY PLC, Borehamwood, Hertfordshire WD6 2HZ (GB)
(72) Inventor: Weinreich, Rudolf Walter, London N20 8LA (GB)
(74) Representative: Maury, Richard Philip

(57) **Abstract**

A composite entry or backing board for use adjacent a printed circuit board during drilling therethrough, in which the adjacent faces of two laminar components of the entry or backing board are joined such that there is no relative slip during transportation, cutting and positioning, and they are separable by peeling them apart after use. The two laminar components are a substrate of fibrous board or paper (B), and a metal or metal alloy foil or sheet (A). The laminar components are joined by an intermediate layer of a low-strength adhesive.

## Description

This invention relates to a method of drilling holes in printed circuit boards and to an entry or backing board adapted for use in such a method.

It is well known that in drilling printed circuit boards it is usual to use dummy boards on either side or both sides of the board or boards to be drilled. These dummy boards are sometimes referred to as backing and entry boards. A backing, or back-up, board is disclosed in US-A-3700341, comprising a laminate of aluminium foil firmly bonded to Masonite, a fibrous board. A laminated entry board is disclosed in US-A-4311419. When many boards are being drilled they are usually made up in stacks consisting of an entry board on top of the printed circuit board material. There are a number of reasons for this - one of these is to reduce burring, another to prevent damage to the top laminate in the stack and another to improve drilling accuracy. At the bottom of the stack there is usually another board called the back-up board which is there for a number of reasons, one of which being to prevent the drills drilling into the base tooling plate of the drilling machine, and another being to prevent burring of the printed circuit board material. Various materials are used for the dummy boards, but the most common dummy boards are composite boards consisting of a metal cladding on one or both sides of a softer, often organic, sheet of material. The metal is rigidly and permanently bonded to the substrate or substrate by means of a permanent adhesive such as an epoxy resin.

Large quantities of these cladded boards are in use and the difficulty of their disposal is a matter for concern. The metal component makes it difficult to dispose of the used boards and the strong adhesion of the metal makes it difficult to reclaim same economically. Strong adhesion has been considered to be important for the rigidity of the board and for its resistance to the torsion of the drill bit. There is thus an environmental problem as well as an economic problem through the failure to recycle the dummy boards.

The invention overcomes this problem by providing a composite entry or backing board for use adjacent a printed circuit board during drilling therethrough, in which the adjacent faces of two laminar components of the entry or backing board are joined such that there is no relative slip during transportation, cutting and positioning, and such that they are separable by peeling them apart after use.

Preferably, the two laminar components are a substrate, which may be fibrous board or paper, and a metal or metal alloy foil or sheet; typical thickness ranges being respectively 0.1 - 4 mm and 0.02 - 1 mm. The substrate thickness is preferably at least 0.020mm, preferably at least 0.20mm, and in many cases at least 0.5mm, and the foil or sheet is preferably at least 0.04mm thick. The laminar components are preferably joined by an intermediate layer of a low-strength, preferably permanent tack, adhesive; alternatively, a similar result may be achieved using an intermediate double-sided adhesive tape. The adhesive materials in each case should preferably be coupled less strongly to the metal or metal alloy component, where one is used, than to the other laminar component, so that it may more readily be recycled.

Alternatively, the laminar components may be joined by keying together their opposed surfaces, by for example roughening or texturing one or both surfaces and pressing them together. Thus the laminar components are joined face to face without any intermediate adhesive.

The join between the laminar components need not extend over their whole area, but may take effect in strips or spots or other partial areas, provided there is sufficient rigidity for the intended application.

In another aspect, the invention provides a method of drilling a printed circuit board, comprising placing an entry or backing board in accordance with the invention defined above next to the printed circuit board and drilling through both boards. In the case where the entry or backing board has two laminar components, the method advantageously includes the further step of peeling off one of the laminar components, i.e. the metal/metal alloy component when such is used, of the board for reclamation.

Examples of the use of the invention will now be given with reference to the accompanying diagrammatic drawings, in which:
Figure 1 is a section through an entry board comprising a fibre board substrate and a cladding on one side only; and
Figure 2 is a section corresponding to Figure 1 but with cladding on both sides of the substrate.

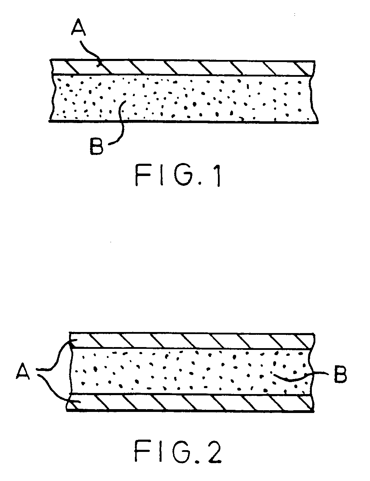

In this embodiment of the present invention, a metal layer may be removed from a substrate after use, thus allowing the substrate to be disposed of and the metal reclaimed. Alternatively the substrate may be reused in some applications. Referring to Figure 1, a weak bond between the metal A and the substrate B may be achieved by means of a low strength adhesive applied to one or both of the contacting surfaces or by an interposed double-sided adhesive tape or by treatment of the surfaces in a way which gives some degree of mechanical keying between them. It is not necessary that the bonding extends completely across the surfaces.

### Example 1

Aluminium sheet 0.25 millimetre thick was attached to a chipboard substrate 1.5 millimetres thick using a low strength permanent tack adhesive. The adhesive was applied to the chipboard using a spraying technique. The performance of the board was comparable to that of conventional boards in terms of rigidity, resistance to torque and the heat of the drill bit, and size of burrs, and the aluminium sheet was readily demountable.

### Example 2

The preferred process uses aluminium 40 microns (0.04mm) thick bonded on to a paper board of approximately 500 microns (0.5mm) thick. The adhesive layer is intended to be the minimum which will hold the layers together during storage, handling, cutting, transportation and positioning. The thickness of the adhesive layer is approximately 3 microns and an ideal peeling force between the aluminium and paper of about 50N/m (Newtons/metre) is achieved. This corresponds to a tensile strength of the bond of about 40kN/m² (kilo Newtons/square metre). Tests have shown that the peeling force must be below 500N/m corresponding to a tensile strength of about 400kN/m².

It will be appreciated that the substrate thickness could be greater than 0.5mm and that the foil or sheet could be of a slightly different thickness.

### Example 3

In a trial of the drill lubricant, the composite board of Example 2 was sprayed on the paper side with fine solid ptfe particles dispersed in a carrier fluid. The carrier evaporated leaving a thin ptfe layer on the paper. The coating weight was about 0.6g of ptfe over each square metre of surface. After drilling 1000 holes through a typical stack of 3 circuit boards with the treated entry board in position no resin build-up was observed on the drill. Another drill used under identical conditions but with no ptfe on the entry board showed considerable resin build-up.

It will be appreciated that the entry board could equally well be used as a backing board.

## Claims

1. A composite entry or backing board for use adjacent a printed circuit board during drilling therethrough, in which the adjacent faces of two laminar components of the entry or backing board are joined such that there is no relative slip during transportation, cutting and positioning, and they are separable by peeling them apart after use.

2. A board according to Claim 1, in which the two laminar components are a substrate of fibrous board or paper, and a metal or metal alloy foil or sheet.

3. A board according to Claim 1 or 2, in which the laminar components are joined by an intermediate layer of a low-strength adhesive.

4. A board according to Claim 2, in which the adhesive material is coupled less strongly to the metal or metal alloy component than to the substrate.

5. A method of drilling a printed circuit board, comprising placing an entry or backing board in accordance with Claim 1 next to the printed circuit board and drilling through both boards.

6. A method according to Claim 5, including the further step of peeling off one of the laminar components of the entry board for reclamation.
